# EUROPÄISCHE PATENTSCHRIFT

(11) **EP 0 472 938 B1**
(45) Veröffentlichungstag und Bekanntmachung des Hinweises auf die Patenterteilung: **19.06.1996**
(21) Anmeldenummer: 91112862.7
(22) Anmeldetag: 31.07.1991
(51) Int. Cl.: G01R 31/303, H01L 21/66

(54) **Anordnung zum Testen und Reparieren einer integrierten Schaltung**
Device for testing and repairing an integrated circuit
Dispositif pour tester et réparer un circuit intégré

(30) Priorität: 27.08.1990 DE 4027062
(43) Veröffentlichungstag der Anmeldung: 04.03.1992
(73) Patentinhaber: ADVANTEST CORPORATION, Shinjuku-ku, Tokyo 163-08 (JP)
(72) Erfinder: Tokunaga, Yasuo, Dr. rer. nat., W-8015 Markt Schwaben (DE); Frosien, Jürgen, Dr.-Ing., W-8012 Ottobrunn (DE)
(74) Vertreter: Tetzner, Volkmar, Dr.-Ing. Dr. jur.

(56) Entgegenhaltungen:
- DE-A- 4 000 579
- JP-A- 1 181 528
- US-A- 4 983 830
- PATENT ABSTRACTS OF JAPAN vol. 13, no. 184 (E-751)28. April 1989
- MICROELECTRONIC ENGINEERING. Bd. 12, Nr. 1/4, Mai 1990, AMSTERDAM NL Seiten 237
- - 240; H.FUJIOKA ET AL.: 'Recent Topics on Electron Beam Testing in Japan'
- JOURNAL OF VACUUM SCIENCE AND TECHNOLOGY: PART B. Bd. 4, Nr. 1, Januar 1986, NEW YORK US Seiten 185 - 188; D.C.SHAVER ET AL.: 'Integrated circuit diagnosis using focused ion beams'
- PATENT ABSTRACTS OF JAPAN vol. 9, no. 147 (E-323)(1870) 21. Juni 1985
- INT. CONF. ON WAFER SCALE INTEGRATION 1989 Januar 1989, SAN FRANCISCO US Seiten 161 - 172; J.F.MCDONALD ET AL.: 'Application of Focused Ion Beam for Testing, Repair and Fabrication of Metal and Optical Interconnections in Wafer Scale Integration'
- MICROELECTRONIC ENGINEERING. Bd. 12, Nr. 1/4, Mai 1990, AMSTERDAM NL Seiten 15 - 26; D.W.RANASINGHE ET AL.: 'Design Verification and Quality Control of Integrated Circuits in an Industrial Environment'
- Patent Abstracts of Japan, Bd. 13, Nr. 468 (E834), veröffentlicht am 23.10.89.
- Patent Abstracts of Japan, Bd.13, Nr. 468 (E834), veröffentlicht am 23.10.89

## Beschreibung

Die Erfindung betrifft eine Anordnung entsprechend dem Gattungsbegriff des Anspruches 1 zum Testen und Reparieren einer integrierten Schaltung.

Es ist bekannt, zum Testen von integrierten Schaltungen ein Elektronenstrahlgerät zu verwenden. Dabei wird die mit einem Eingangssignal beaufschlagte integrierte Schaltung mit einem Elektronenstrahl abgetastet. Die an einer bestimmten Meßstelle erzeugten Sekundärelektronen werden in ein entsprechendes elektrisches Ist-Signal umgewandelt und mit dem durch das Eingangssignal bestimmten Soll-Signal verglichen. Die Reparatur einer als fehlerhaft erkannten integrierten Schaltung erfolgt dann in einem Ionenstrahlgerät.

Das Umsetzen der integrierten Schaltung aus dem Elektronenstrahlgerät in das Ionenstrahlgerät hat jedoch zur Folge, daß die fehlerhafte Stelle der integrierten Schaltung erneut aufgesucht werden muß, bevor die eigentliche Reparatur mit dem Ionenstrahl erfolgen kann. Die anschließende Überprüfung der erfolgten Reparatur muß wieder in einem Elektronenstrahlgerät durchgeführt werden.

Neben dem großen Zeitaufwand sind für ein derartiges Test- und Reparaturverfahren viele und teure Geräte erforderlich.

Aus der JP-A-1-181 528 ist eine Anordnung gemäß dem Oberbegriff des Anspruchs 1 bekannt. Bei dieser bekannten Anordnung entfällt das zeitaufwendige Umsetzen der integrierten Schaltung zwischen einer Vorrichtung zum Testen und einer Vorrichtung zum Reparieren. Nachdem der erzeugte Ionenstrahl sowohl zum Testen als auch zum Reparieren der integrierten Schaltung verwendet wird, reicht eine einzige Strahlerzeugungseinrichtung aus, wodurch sich der Kostenaufwand erheblich reduziert.

Der Erfindung liegt die Aufgabe zugrunde, die Anordnung entsprechend dem Gattungsbegriff des Anspruches 1 derart weiterzubilden, daß die Zeit für die Entwicklung einer Schaltung weiter reduziert wird.

Diese Aufgabe wird erfindungsgemäß dadurch gelöst, daß eine mit der Vorrichtung zum Testen der integrierten Schaltung verbundene datenverarbeitende Anlage vorgesehen ist, die über sämtliche Schaltungsdaten der getesteten integrierten Schaltung verfügt und in der die beim Reparieren entstandene neue integrierte Schaltung abgespeichert ist.

Weitere Merkmale der Erfindung sind Gegenstand der Unteransprüche und werden in der Zeichnung und der folgenden Beschreibung näher erläutert.

In der Zeichnung zeigen
- Fig.1: eine schematische Darstellung eines ersten Ausführungsbeispieles,
- Fig.2: eine schematische Darstellung eines zweiten Ausführungsbeispieles,
- Fig.3: eine schematische Darstellung eines Ausführungsbeispieles eines Sekundärelektronenspektrometers,
- Fig.4, 4a bis 4g: Menüdarstellungen auf einem Bildschirm.

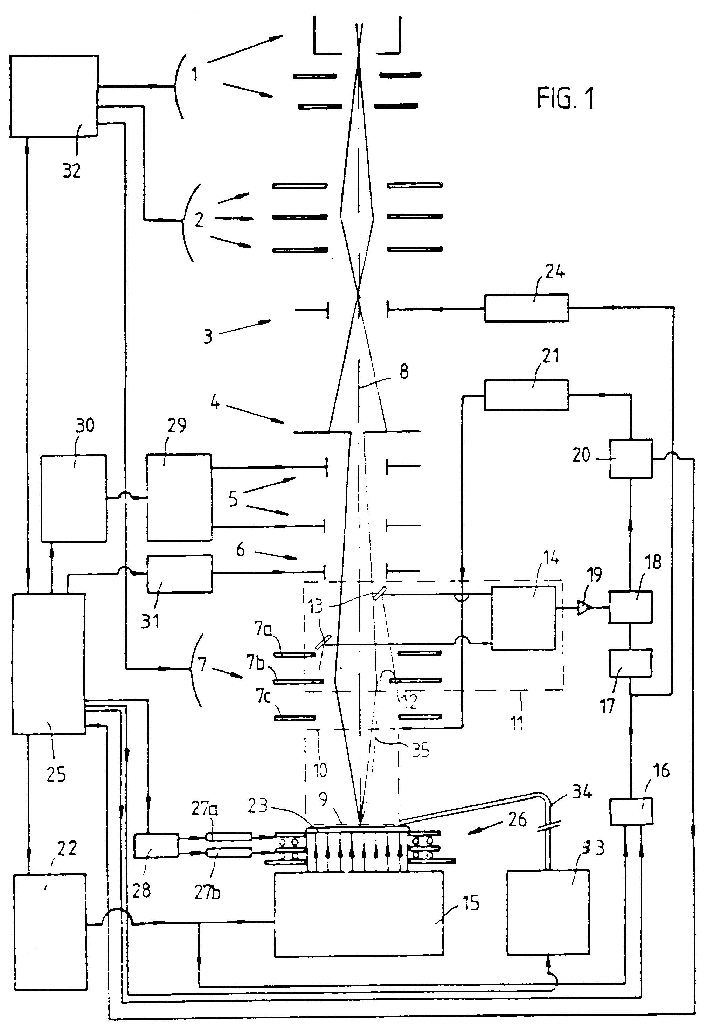

Das in Fig.1 dargestellte Ausführungsbeispiel einer Anordnung zum Testen und Reparieren einer integrierten Schaltung enthält eine Ionenquelle 1, eine Kondensorlinse 2, ein Austastsystem 3, eine Aperturblende 4, eine Ablenkeinrichtung 5, einen Stigmator 6 sowie eine Objektivlinse 7. Die Objektivlinse 7 enthält drei in Strahlrichtung hintereinander angeordnete, rotationssymmetrische Elektroden 7a, 7b, 7c, wobei die Achse 8 des Ionenstrahls mit der Achse der Objektivlinse 7 zusammenfällt.

In diese Anordnung ist ferner ein Sekundärelektronenspektrometer integriert, das im wesentlichen eine Extraktionselektrode 9, eine Filterelektrode 10, einen Sekundärelektronendetektor 11 und einen noch näher zu erläuternden Regelkreis enthält.

Der Sekundärelektronendetektor 11 besteht im wesentlichen aus einem Szintillator 12, der durch den inneren Bereich der mittleren Elektrode 7b der Objektivlinse 7 gebildet wird, ferner aus einem Spiegel 13 (oder einer sonstigen Optik) sowie einem Multiplier 14. Statt dessen kann der Szintillator 12 auch über einen Lichtleiter mit dem Multiplier 14 verbunden sein.

Die Einrichtung zur Beaufschlagung einer integrierten Schaltung 23 mit einem Eingangssignal wird durch einen LSI-Tester 22 gebildet, der über einen Testkopf 15 mit der integrierten Schaltung 23 verbunden ist.

Der Regelkreis, der den Szintillator 12 mit der Filterelektrode 10 verbindet, enthält den LSI-Tester 22 mit Testkopf 15, eine Phasensteuerung 16, eine Verzögerungseinrichtung 17, eine Torsteuerung 18, einen Vorverstärker 19, eine signalverarbeitende Schaltung 20 sowie einen Verstärker 21, dessen Ausgang an die Filterelektrode 10 angeschlossen ist.

Der mit der Verzögerungseinrichtung 17 verbundene Ausgang der Phasensteuerung 16 ist weiterhin über einen Pulsgenerator 22 an das Austastsystem 3 angeschlossen.

Eine datenverarbeitende Anlage 25 steuert den LSI-Tester 22 sowie die Phasensteuerung 16 an. Ein entsprechendes Rücksignal wird von der signalverarbeitenden Schaltung 20 zur datenverarbeitenden Anlage 25 geführt.

Die zu untersuchende integrierte Schaltung 23 befindet sich auf einem Tisch 26, der beliebig in senkrechter Richtung zur Achse der Objektivlinse 7 verschiebbar ist. Die Verschiebung erfolgt durch zwei von der datenverarbeitenden Anlage 25 über eine Steuereinheit 28 gesteuerte Motoren 27a, 27b.

Zur Betätigung der Ablenkeinrichtung 5 ist ein Treiber 29 vorgesehen, der über eine Steuerung 30 von der datenverarbeitenden Anlage 25 angetrieben wird. Der Stigmator 6 ist über eine Steuerung 31 ebenfalls mit der datenverarbeitenden Anlage 25 verbunden. Eine weitere mit der datenverarbeitenden Anlage 25 in Verbindung stehende Steuerung 32 steuert die Ionenquelle 1, die Kondensorlinse 2 und die Objektivlinse 7.

Zur Abscheidung von leitendem Material auf der integrierten Schaltung 23 ist eine Abscheidevorrichtung 33 mit einer Düse 34 vorgesehen, die auch über die datenverarbeitende Anlage 25 angesteuert wird.

Mit der Anordnung gemäß Fig.1 ist einerseits eine Vorrichtung zum Testen und andererseits eine Vorrichtung zum Reparieren einer integrierten Schaltung verwirklicht. Zunächst wird die Funktionsweise während des Testvorganges näher beschrieben:

Der auf die integrierte Schaltung 23 fokussierte Ionenstrahl löst, in Abhängigkeit vom Potential an dieser Stelle, eine entsprechende Anzahl an Sekundärelektronen 35 aus.

Das allgemeine Prinzip des Regelkreises besteht darin, das Sekundärelektronensignal auf konstanten Strom zu regeln und gleichzeitig die Phasensteuerung für das Austastsystem 3 des Ionenstrahls zu erzeugen.

Die vom Ionenstrahl beim Auftreffen auf die Probe 23 ausgelösten Sekundärelektronen 35 müssen nach Passieren der Extraktionselektrode 9 zunächst die Filterelektrode 10 passieren. Da die Filterelektrode auf einem bestimmten negativen Potential liegt (das - wie noch erläutert wird - vom Regelkreis gesteuert wird), werden nur die Sekundärelektronen durch die Filterelektrode 10 durchgelassen, die eine genügend hohe Energie besitzen.

Wenn sich das Potential an der untersuchten Meßstelle der integrierten Schaltung 23 ändert, verschiebt sich die Energieverteilung der Sekundärelektronen und es kommen entsprechend mehr oder weniger Elektronen zum Szintillator 12 des Sekundärelektronendetektors 11. Nunmehr wird das Potential der Filterelektrode 10 so nachgeregelt, daß der Sekundärelektronenstrom konstant bleibt. Das Potential der Filterelektrode 10 wird somit in Abhängigkeit von dem zu messenden Potential auf der integrierten Schaltung 23 geändert. Damit stellt das sich ändernde Potential der Filterelektrode 10 ein Maß für das zu messende Potential der integrierten Schaltung 23 dar.

Im einzelnen arbeitet der äußere Regelkreis wie folgt: Der Sekundärelektronendetektor 11 wandelt die durch den Ionenstrahl an der Meßstelle erzeugten Sekundärelektronen - sofern sie die Filterelektrode 10 passieren - in ein elektrisches Ist-Signal um, das nach Verstärkung im Vorverstärker 19 durch die Torsteuerung 18 abgetastet wird. Diese Abtastung wird durch den LSI-Tester 22 gesteuert, der zugleich auch über den Testkopf 15 die zu untersuchende integrierte Schaltung 23 treibt. Die Phasensteuerung 16 ermöglicht hierbei die Einstellung des Abtastzeitpunktes.

Vom Ausgang der Phasensteuerung 16 wird über den Pulsgenerator 24 das Austastsystem 3 des Ionenstrahls gesteuert. Um die Laufzeit des Ionenstrahls vom Austastsystem 3 bis zur integrierten Schaltung 23 zu berücksichtigen, ist die Verzögerungseinrichtung 17 vorgesehen.

Die Einrichtung zum Vergleichen des umgewandelten Ist-Signals mit dem Soll-Signal wird durch die signalverarbeitende Schaltung 20 gebildet. In der signalverarbeitenden Schaltung 20 kann das über die Torsteuerung 18 abgetastete Ausgangssignal des Vorverstärkers 19 gemittelt werden, um das Signal-Rausch-Verhältnis zu verbessern. Mittels eines Komparators wird ein Vergleich mit dem Soll-Signal durchgeführt, der dem gewünschten konstanten Sekundärelektronenstrom entspricht. Das Ausgangssignal gelangt über den Verstärker 21 zur Filterelektrode 10 und hält in der bereits erläuterten Weise durch Änderung des negativen Potentials der Filterelektrode 10 den Sekundärelektronenstrom konstant, auch wenn sich das zu messende Potential auf der untersuchten Meßstelle der integrierten Schaltung 23 ändert.

Statt eines Austastsystems 3 zum Austasten (Blanken) des Ionenstrahls kann im Rahmen der Erfindung selbstverständlich auch eine gepulste Ionenquelle Verwendung finden.

Der Ionenstrahl kann durch Verschiebung des Tisches 26 mittels der Motoren 27a, 27b über die Steuereinheit 28 auf jede beliebige Meßstelle der integrierten Schaltung 23 eingestellt werden. Ferner besteht die Möglichkeit, den Ionenstrahl über die Steuerung 30 und den Treiber 29 der Ablenkeinrichtung 5 auf der integrierten Schaltung zu verschieben. Die Relativbewegung von Ionenstrahl und integrierter Schaltung 23 kann im Rahmen der Erfindung auch dadurch gelöst werden, daß beispielsweise die Achse 8 des Ionenstrahls und damit die gesamte Apparatur senkrecht zur integrierten Schaltung 23 verschoben wird.

Über den Testkopf 15 wird die integrierte Schaltung 23 vom LSI-Tester 22 mit einem Eingangssignal beaufschlagt, und das entstehende Ausgangssignal wird wiederum über den Testkopf 15 zum LSI-Tester 22 weitergeleitet. Auf diese Weise ergibt sich die Information, ob ein Fehler in der Schaltung vorliegt. Liegt ein Fehler vor, werden vom LSI-Tester 22 verschiedene Testprogramme erzeugt, um den Fehler einzugrenzen.

Nach dieser groben Fehlerlokalisierung muß gezielt im Schaltungsinneren gemessen werden. Mittels eines CAD-Systems und der elektrischen Beschreibung der integrierten Schaltung 23 werden Meßstellen festgelegt. Die einzelnen Meßstellen werden vom Ionenstrahl angefahren, um dort Potentialmessungen in der oben beschriebenen Art und Weise durchzuführen.

Die datenverarbeitende Anlage 25 erhält von der signalverarbeitenden Schaltung 20 an jeder Meßstelle die Information, ob eine Abweichung des Ist-Signales gegenüber dem Soll-Signal vorliegt. Diese Messungen werden an verschiedenen Meßstellen wiederholt durchgeführt, bis der Fehler exakt lokalisiert ist. Dabei richtet sich zweckmäßigerweise die Wahl der einzelnen Meßstellen nach den Ergebnissen der vorangegangenen Messungen. Dies kann entweder automatisch von der datenverarbeitenden Anlage 25 oder vom Operator erfolgen.

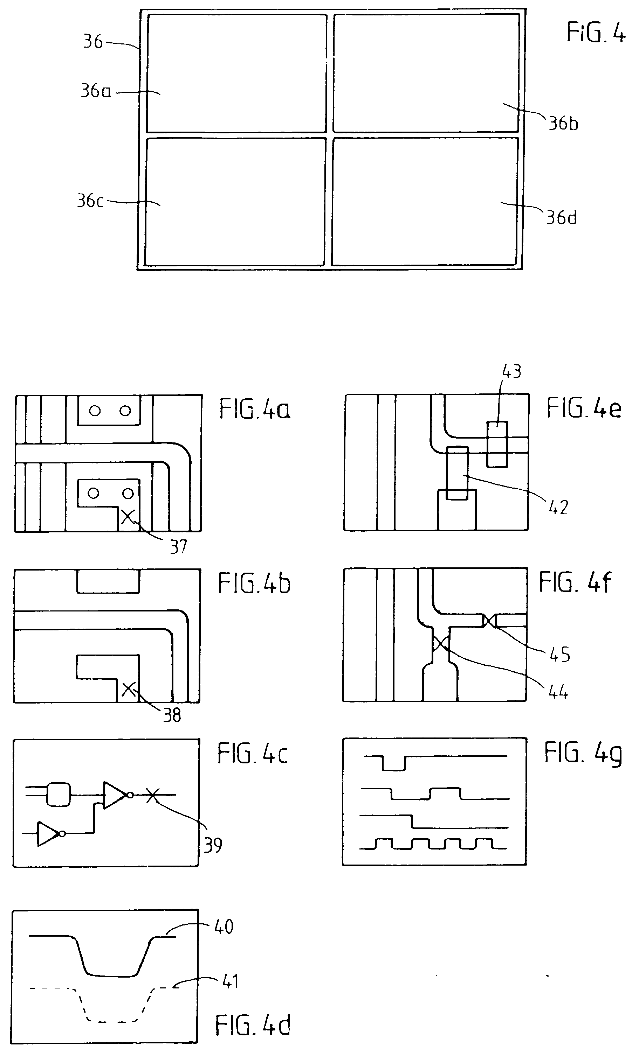

Auf einem in Fig.4 dargestellten Bildschirm 36 der datenverarbeitenden Anlage 25 können von der zu untersuchenden integrierten Schaltung 23 verschiedene Darstellungen angezeigt werden. Die Figuren 4a bis 4g zeigen mögliche Menüs, die auf dem Bildschirm 36 in beliebiger Weise kombiniert werden können.

Fig.4a zeigt ein sogenanntes SEM-Bild eines Ausschnittes aus der integrierten Schaltung 23, das durch Rasterung der integrierten Schaltung mit dem Ionenstrahl entstanden ist. Mit dem Bezugszeichen 37 ist die gerade zu untersuchende Meßstelle bezeichnet.

Fig.4b zeigt über den gleichen Ausschnitt der integrierten Schaltung 23 das entsprechende CAD-Layout, wobei die der Meßstelle 37 entsprechende Position 38 aus dem Layout gezeigt ist.

Fig.4c veranschaulicht ein CAD-Blockschaltbild, wobei die Meßstelle 37 bzw. die Position 38 mit der entsprechenden Position 39 im Blockschaltbild bezeichnet ist.

Der Wellenform 40 in Fig.4d entspricht die Wellenform 41 beispielsweise dem an der Meßstelle 37 gemessenen Wellenformsignal. Die Wellenform 40 ist durch Simulation entstanden, so daß der Operator am Bildschirm feststellen kann, ob zwischen gemessener und simulierter Wellenform Abweichungen bestehen.

Ist der Fehler eindeutig lokalisiert, läßt sich mit Hilfe der Anordnung zum Testen und Reparieren einer integrierten Schaltung unmittelbar auch die Reparatur durchführen, ohne daß die integrierte Schaltung 23 umgesetzt werden muß. Die in dieser Anordnung vorgesehene Vorrichtung zur Reparatur einer integrierten Schaltung verwendet ebenfalls einen Ionenstrahl. Dabei bildet der für die Reparatur verwendete Ionenstrahl zugleich den für den Testvorgang benutzten Ionenstrahl. Die Erzeugung dieses Strahles erfolgt in einer einzigen Strahlerzeugungseinrichtung, nämlich der Ionenquelle 1.

Zur Reparatur einer integrierten Schaltung stehen im wesentlichen zwei Möglichkeiten zur Verfügung. Einerseits können mit dem Ionenstrahl Leiterbahnen aufgetrennt werden, und andererseits kann durch eine Abscheideeinrichtung leitendes Material auf die integrierte Schaltung aufgebracht werden, so daß neue Leitungsverbindungen entstehen.

Welche dieser beiden Möglichkeiten zur Behebung einer Fehlerstelle angewandt wird, hängt vom Einzelfall ab. In Fig.4e ist ein CAD-Layout dargestellt, wobei die Stellen der Abscheidung 42 und der Auftrennung 43 angedeutet sind. In Fig.4f kann wiederum in einem CAD-Layout die durch Abscheidung neu entstandene Leiterbahn 44 und die aufgeschnittene Stelle 45 beobachtet werden.

Der Abscheidevorgang erfolgt durch Steuerung der Abscheideeinrichtung 33 über die datenverarbeitende Anlage 25, wobei die Austrittsöffnung der Düse 34 durch Verfahren des Tisches 26 in die richtige Position gebracht wird.

Fig.4g zeigt ein Kontrollmenü, in dem die durch Simulation und/oder Messungen entstandenen Wellenformsignale zusammengestellt werden können.

Die Menüs gemäß den Fig.4a bis 4g sind nur als beispielhafte Zusammenstellungen anzusehen und können für spezielle Anwendungen entsprechend abgeändert bzw. ergänzt werden. Die Zahl der auf dem Bildschirm 36 gleichzeitig angezeigten Menüs ist keineswegs auf die in Fig.4 dargestellte Anzahl von vier Menüs 36a bis 36d beschränkt. Vielmehr können je nach Anwendung nur ein Menü oder auch beliebig viele Menüs kombiniert werden. Die Verwirklichung der Vorrichtung zum Testen und der Vorrichtung zum Reparieren in einer Anordnung, wobei nur eine einzige Strahlerzeugungseinrichtung vorgesehen ist, erweist sich besonders in folgenden Punkten als hilfreich:
a) Der LSI-Tester 22 kann die integrierte Schaltung 23 mit einem Eingangssignal beaufschlagen, so daß unmittelbar bestätigt werden kann, ob der angefahrene Meßpunkt genau der lokalisierten Fehlerstelle entspricht.
b) Der LSI-Tester 22 kann schnell und leicht prüfen, ob beispielsweise eine Leiterbahn wirklich aufgetrennt worden ist, oder ob die durch abgeschiedenes Material neu entstandene Leiterbahn guten und gezielten Kontakt mit anderen Leiterbahnen hat.

Die datenverarbeitende Anlage 25 verfügt über sämtliche Schaltungsdaten der integrierten Schaltung 23, wie beispielsweise Blockschaltbilder, Layout- und Maskendaten. Die neue, durch eine Reparatur entstandene integrierte Schaltung ist wiederum in der datenverarbeitenden Anlage abgespeichert, und es können neue Simulationen für diese Schaltung vorgenommen werden. Die Zeit für eine Schaltungsentwicklung läßt sich auf diese Weise deutlich reduzieren.

Die Anordnung zum Testen und Reparieren ist demnach nicht nur für fertige integrierte Schaltungen - die lediglich noch einmal überprüft werden sollen - verwendbar, sondern auch für den Schaltungsaufbau in der Entwicklungsphase einsetzbar. In diesem Zusammenhang ist es auch denkbar, im Rahmen der Erfindung eine weitere Einrichtung vorzusehen, mit deren Hilfe Bauteile, wie beispielsweise Widerstände oder Transistoren auf die integrierte Schaltung aufgebracht werden können.

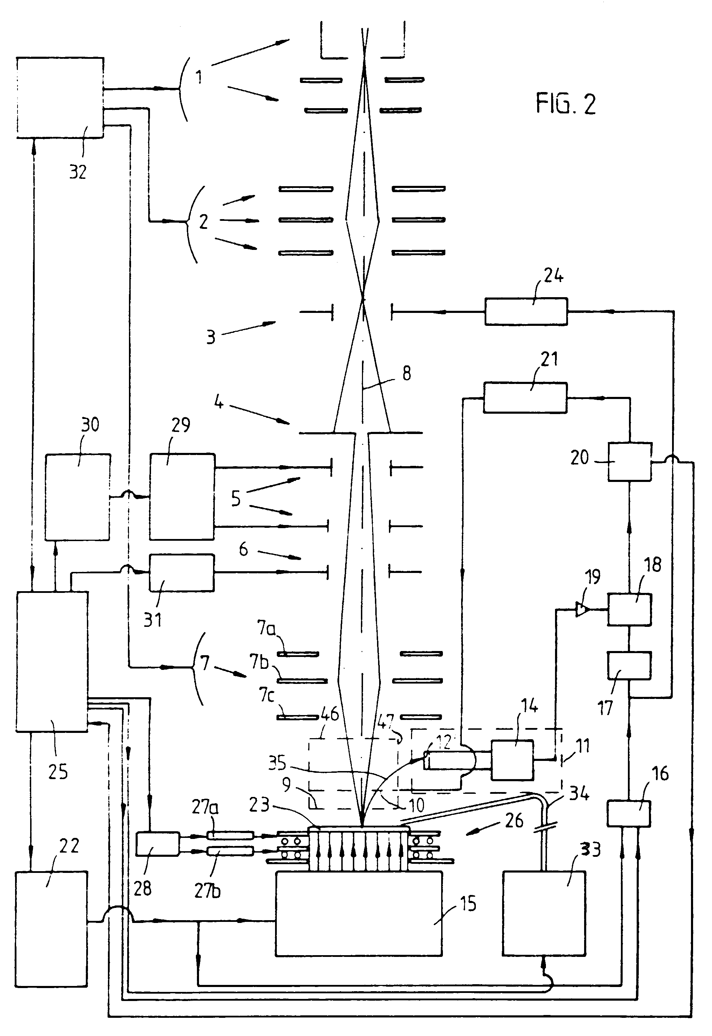

Im ersten Ausführungsbeispiel gemäß Fig.4 wird der Szintillator 12 durch die mittlere Elektrode 7b der Objektivlinse 7 gebildet. Im Ausführungsbeispiel gemäß Fig.2 ist der Szintillator 12' außerhalb der Objektivlinse 7 angeordnet.

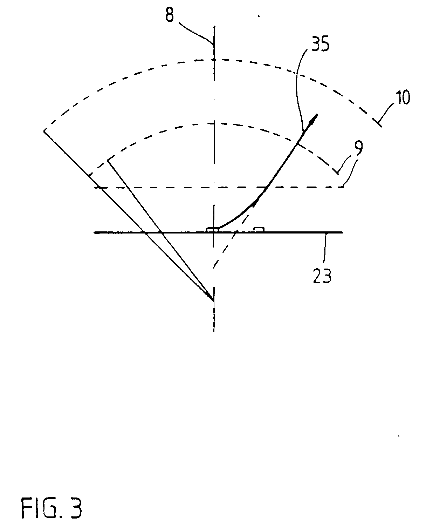

Das Sekundärelektronenspektrometer enthält neben der Extraktionselektrode 9 und der Filterelektrode 10 eine Druckelektrode 46 sowie eine Umlenkelektrode 47. Die Druckelektrode 46 und die Umlenkelektrode 47 gewährleisten dabei, daß die erzeugten Sekundärelektronen nach Passieren der Filterelektrode 10 den seitlich neben dem Sekundärelektronenspektrometer angeordneten Szintillator 12' erreichen. Im übrigen ist der Aufbau und die Funktionsweise analog zum Ausführungsbeispiel gemäß Fig.1. Die Extraktionselektrode 9 und die Filterelektrode 10 sind in Fig.2 als planare Netze dargestellt, können jedoch vorteilhafterweise auch als Kugelnetze ausgebildet sein, wie dies in Fig.3 dargestellt ist.

## Patentansprüche

1. Anordnung zum Testen und Reparieren einer integrierten Schaltung (23) mittels einen Ionenstrahls, enthaltend
a) eine Ionenquelle (1) zur Erzeugung eines zum Testen und Reparieren dienenden Ionenstrahles,
b) eine Vorrichtung zum Testen der integrierten Schaltung (23) mittels des Ionenstrahles, mit
a1) einer Einrichtung (22) zur Beaufschlagung der integrierten Schaltung (23) mit einem Eingangssignal,
a2) einer Einrichtung (11) zur Umwandlung der durch den Ionenstrahl an einer Meßstelle erzeugten Sekundärelektronen (35) in ein elektrisches Ist-Signal,
a3) sowie einer Einrichtung (20) zum Vergleichen des umgewandelten Ist-Signals mit einem durch das Eingangssignal bestimmten Soll-Signal,
c) sowie eine Vorrichtung zum Reparieren der als fehlerhaft erkannten integrierten Schaltung (23) mittels des Ionenstrahles,
dadurch gekennzeichnet, daß
d) eine mit der Vorrichtung zum Testen der integrierten Schaltung verbundene datenverarbeitende Anlage (25) vorgesehen ist, die über sämtliche Schaltungsdaten der getesteten integrierten Schaltung (23) verfügt und in der die beim Reparieren entstandene neue integrierte Schaltung abgespeichert ist.

2. Anordnung nach Anspruch 1, gekennzeichnet durch folgende weitere Merkmale:
a) eine Einrichtung (5) zur Ablenkung des Ionenstrahls,
b) eine den Ionenstrahl auf die integrierte Schaltung (23) fokussierende elektrostatische Objektivlinse (7), die drei in Strahlrichtung hintereinander angeordnete, rotationssymmetrische Elektroden (7a, 7b, 7c) enthält, wobei die Achse (8) des Ionenstrahls mit der Achse der Objektivlinse zusammenfällt,
c) ein integriertes Sekundärelektronenspektrometer, das eine Extraktionselektrode (9), eine Filterelektrode (10), einen Szintillator (12) sowie einen den Szintillator (12) mit der Filterelektrode (10) verbindenden Regelkreis enthält.

3. Anordnung nach Anspruch 1, dadurch gekennzeichnet, daß die Extraktionselektrode (9) und die Filterelektrode (10) zwischen der zu untersuchenden integrierten Schaltung (23) und der der integrierten Schaltung benachbarten Elektrode (7c) der Objektivlinse (7) angeordnet sind.

4. Anordnung nach Anspruch 1, dadurch gekennzeichnet, daß die Vorrichtung zum Reparieren der als fehlerhaft erkannten integrierten Schaltung (23) eine Einrichtung (33) zur Abscheidung von leitendem Material auf die integrierte Schaltung (23) enthält.

5. Anordnung nach den Ansprüchen 1 und 2, dadurch gekennzeichnet, daß die Einrichtung (22) zur Beaufschlagung der integrierten Schaltung (23) mit einem Eingangssignal und der den Szintillator (12) mit der Filterelektrode (10) verbindende Regelkreis mit der datenverarbeitenden Anlage (25) in Verbindung stehen.

6. Anordnung nach Anspruch 2, dadurch gekennzeichnet, daß der Szintillator (12) durch die mittlere Elektrode (7b) der Objektivlinse (7) gebildet wird.

7. Anordnung nach Anspruch 2, dadurch gekennzeichnet, daß der Szintillator (12') außerhalb der Objektivlinse (7) angeordnet ist.

## Claims

1. Arrangement for testing and repairing an integrated circuit (23) by means of an ion beam, containing
a) an ion source (1) for generating an ion beam which serves for testing and repairing.
b) a device for testing the integrated circuit (23) by means of the ion beam, with
a1) an arrangement (22) for applying an input signal to the integrated circuit (23),
a2) an arrangement (11) for conversion of the secondary electrons (35) generated by the ion beam at a measurement point into an electrical actual-value signal,
a3) as well as an arrangement (20) for comparing the converted actual-value signal with a theoretical-value signal determined by the input signal,
c) as well as a device for repairing the integrated circuit (23) which has been recognised as defective by means of the ion beam,
characterised in that
d) a data processor (25) is provided which is connected to the device for testing the integrated circuit and has available to it all the circuitry data of the tested integrated circuit (23) and in which the new integrated circuit produced during repair is memorised.

2. Arrangement as claimed in claim 1, characterised by the following further features:
a) an arrangement (5) for deflecting the ion beam,
b) an electrostatic objective lens (7) which focuses the ion beam onto the integrated circuit (23) and contains three rotationally symmetrical electrodes (7a, 7b, 7c) arranged behind one another in the beam direction, the axis (8) of the ion beam coinciding with the axis of the objective lens,
c) an integrated secondary electron spectrometer which contains an extraction electrode (9), a filter electrode (10), a scintillator (12) and a control circuit which connects the scintillator (12) to the filter electrode (10).

3. Arrangement as claimed in claim 1, characterised in that the extraction electrode (9) and the filter electrode (10) are arranged between the integrated circuit (23) to be examined and the electrode (7c) of the objective lens (7) adjacent to the integrated circuit.

4. Arrangement as claimed in claim 1, characterised in that the device for repairing the integrated circuit (23) which has been recognised as defective contains an arrangement (33) for deposition of conductive material onto the integrated circuit (23).

5. Arrangement as claimed in claims 1 and 2, characterised in that the arrangement (22) for applying an input signal to the integrated circuit (22) and the control circuit which connects the scintillator (12) to the filter electrode (10) are connected to a data processor (25).

6. Arrangement as claimed in claim 2, characterised in that the scintillator (12) is formed by the central electrode (7b) of the objective lens (7).

7. Arrangement as claimed in claim 2, characterised in that the scintillator (12') is arranged outside the objective lens (7).

## Revendications

1. Dispositif d'essai et de réparation d'un circuit intégré (23) au moyen d'un faisceau ionique, comprenant :
a) une source d'ions (1) pour la génération d'un faisceau ionique servant à l'essai et à la réparation,
b) un dispositif d'essai du circuit intégré (23) au moyen du faisceau ionique, comprenant
a1) un dispositif (22) pour envoyer un signal d'entrée au circuit intégré (23),
a2) un dispositif (11) de conversion des électrons secondaires (35) générés par le faisceau ionique en un lieu de mesure en un signal électrique réel,
a3) ainsi qu'un dispositif (20) de comparaison du signal réel converti avec un signal de consigne déterminé par le signal d'entrée,
c) ainsi qu'un dispositif de réparation du circuit intégré (23), dont il a été observé qu'il est défectueux, au moyen du faisceau ionique,
caractérisé en ce que :
d) une installation de traitement des données (25) qui est prévue, qui dispose de toutes les données du circuit intégré testé (23) et dans laquelle le nouveau circuit intégré résultant de la réparation est mémorisé, est reliée au dispositif d'essai du circuit intégré.

2. Dispositif selon la revendication 1, caractérisé par les autres particularités suivantes :
a) un dispositif (5) de déviation du faisceau ionique,
b) une lentille électrostatique d'objectif (7) focalisant le faisceau ionique sur le circuit intégré (23) et comprenant trois électrodes symétriques de révolution (7a, 7b, 7c) disposées successivement dans le sens du faisceau, l'axe (8) du faisceau ionique coïncidant avec l'axe de la lentille d'objectif,
c) un spectromètre intégré d'électrons secondaires qui comprend une électrode d'extraction (9), une électrode de filtrage (10), un scintillateur (12) ainsi qu'un circuit de réglage reliant le scintillateur (12) à l'électrode de filtrage (10).

3. Dispositif selon la revendication 1, caractérisé en ce que l'électrode d'extraction (9) et l'électrode de filtrage (10) sont disposées entre le circuit intégré à étudier (23) et l'électrode (7c) de la lentille d'objectif (7) qui est voisine du circuit intégré.

4. Dispositif selon la revendication 1, caractérisé en ce que le dispositif de réparation du circuit intégré (23), dont il a été observé qu'il est défectueux, comprend un dispositif (33) de dépôt de matériau conducteur sur le circuit intégré (23).

5. Dispositif selon les revendications 1 et 2, caractérisé en ce que le dispositif (22) destiné à envoyer un signal d'entrée au circuit intégré (23) et le circuit de réglage reliant le scintillateur (12) à l'électrode de filtrage (10) sont en liaison avec l'installation de traitement des données (25).

6. Dispositif selon la revendication 2, caractérisé en ce que le scintillateur (12) est formé de l'électrode centrale (7b) de la lentille d'objectif (7).

7. Dispositif selon la revendication 2, caractérisé en ce que le scintillateur (12') est disposé à l'extérieur de la lentille d'objectif (7).
